(19) Europäisches Patentamt
European Patent Office
Office européen des brevets

(11) **EP 3 360 151 B1**

(12) **FASCICULE DE BREVET EUROPEEN**

(45) Date de publication et mention
de la délivrance du brevet:
**20.11.2019 Bulletin 2019/47**

(21) Numéro de dépôt: **16778316.6**

(22) Date de dépôt: **03.10.2016**

(51) Int Cl.:
*H01J 25/04* *(2006.01)*   *H01J 23/16* *(2006.01)*

(86) Numéro de dépôt international:
**PCT/EP2016/073548**

(87) Numéro de publication internationale:
**WO 2017/060189 (13.04.2017 Gazette 2017/15)**

(54) **EQUILIBRAGE D'UN TUBE A SORTIE INDUCTIVE MULTIFAISCEAU**

ÄQUILIBRIERUNG EINES MEHRSTRAHLIGEN INDUKTIVEN AUSGANGSROHRS

EQUILIBRATION OF A MULTIBEAM INDUCTIVE OUTPUT TUBE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.10.2015 FR 1502085**

(43) Date de publication de la demande:
**15.08.2018 Bulletin 2018/33**

(73) Titulaire: **Thales**
**92400 Courbevoie (FR)**

(72) Inventeur: **BEL, Claude**
**74500 Maxilly Sur Leman (FR)**

(74) Mandataire: **Collet, Alain**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A2- 0 883 152    FR-A1- 2 860 916**

- **R Lawrence Ives: "Development of a 200 MHz 30 MW Multiple Beam Inductive Output Tube Final Report", , 19 juin 2008 (2008-06-19), XP055292528, Extrait de l'Internet: URL:http://www.osti.gov/scitech/servlets/p url/934376 [extrait le 2016-08-01]**
- **R.L. IVES ET AL: "350 MHZ, 200 KW CW multiple beam inductive output tube", PLASMA SCIENCE (ICOPS), 2011 ABSTRACTS IEEE INTERNATIONAL CONFERENCE ON, 1 juin 2011 (2011-06-01), pages 1-1, XP055292537, DOI: 10.1109/PLASMA.2011.5992911 ISBN: 978-1-61284-330-8**

## Description

L'invention concerne un amplificateur à tube à sortie inductive. Un tel tube est bien connu dans la littérature anglo-saxonne sous le nom d'IOT (Inductive Output Tube). Le tube comporte dans une enceinte à vide, un canon générant un faisceau d'électrons traversant une anode et un espace d'interaction avant d'atteindre un collecteur. L'espace d'interaction est situé dans une cavité résonnante. Un signal d'entrée introduit au niveau du canon à électrons est amplifié au niveau de la cavité résonnante. Les tubes à sortie inductive sont notamment utilisés comme dernier étage d'amplification d'un signal radiofréquence, la sortie du tube étant connectée à une charge comme par exemple une cavité accélératrice.

Le canon à électrons comporte une cathode et une grille de commande entre lesquelles est appliqué un signal radiofréquence à amplifier qui module l'énergie du faisceau d'électrons. Dans l'espace d'interaction, une partie de l'énergie cinétique du faisceau d'électrons est convertie en onde électromagnétique dans la cavité résonnante.

Il existe des tubes multifaisceaux. Ces tubes sont connus dans la littérature anglo-saxonne sous le nom de MBIOT (Multiple Beam Inductive Output Tube). Plus précisément, afin d'augmenter la puissance de sortie du tube on peut disposer plusieurs faisceaux d'électrons en interaction avec une seule cavité résonnante. Les différents faisceaux sont générés chacun par un canon à électrons. Les grilles des différents canons reçoivent le même signal radiofréquence à amplifier.

L'invention vise à améliorer les performances et en particulier le rendement global d'un tube multifaisceau et pour ce faire, la demanderesse s'est rendu compte que le rendement était lié à l'équilibrage de la densité des différents faisceaux d'électrons. Pour un même signal radiofréquence appliqué en entrée des différents canons à électrons, chacun doit fournir le même courant crête. Lors de la fabrication d'un tube des dispersions géométriques interviennent obligatoirement. Ces dispersions entrainent des variations de densité entre les faisceaux émis par les différents canons.

Une solution consiste réduire les tolérances de fabrication mais cela tend à augmenter le coût de revient d'un tube.

L'invention vise à palier ce problème en acceptant d'élargir les tolérances de fabrication. L'invention propose une solution pour équilibrer la densité des différents faisceaux tout en acceptant des dispersions géométriques.

A cet effet, l'invention a pour objet un amplificateur comprenant un tube à sortie inductive multifaisceau comprenant une cavité de sortie et plusieurs canons à électrons destinés chacun à émettre un faisceau d'électrons traversant la cavité de sortie, chaque canon à électrons comprenant une cathode destinée à émettre le faisceau d'électrons et une grille permettant de moduler la densité du faisceau d'électrons, l'amplificateur comprenant en outre, associée à chaque canon, une alimentation en tension continue, chacune des alimentations étant raccordée à la grille du canon à électrons correspondant de façon à polariser la grille, la tension d'au moins une des alimentations étant réglable de façon à équilibrer la densité des différents faisceaux d'électrons.

Les alimentations associées à chaque canon à électrons sont par exemple appelées premières alimentations. L'amplificateur comprend en outre une seconde alimentation en tension continue réglable en tension, les premières alimentations étant chacune raccordée en série entre la grille correspondante et la seconde alimentation, la tension de la seconde alimentation étant réglable de façon à appliquer aux différentes grilles une tension de blocage.

L'amplificateur peut comprendre en outre, associé à chacun des canons à électrons, un collecteur, chaque collecteur étant destiné à recevoir le faisceau d'électrons correspondant après son passage dans la cavité de sortie, un capteur de courant permettant de mesurer un courant circulant dans chacun des collecteurs.

L'invention a également pour objet un procédé de réglage d'un amplificateur selon l'invention, le procédé consistant à mesurer un courant circulant dans chacun des collecteurs et à régler la tension de chacune des premières alimentations pour rendre égales les valeurs mesurées des courants.

Avantageusement, une valeur cible de courant mesuré dans chacun des collecteurs est définie de façon à limiter l'échauffement de chacun des collecteurs.

Une tension peut être appliquée à une des grilles, tension permettant d'atteindre une valeur cible de courant mesuré dans chacun des collecteurs durant une fraction d'une période de temps.

La période de temps est avantageusement répétée et on calcule une moyenne des mesures de courant réalisées durant chacune les fractions.

L'invention sera mieux comprise et d'autres avantages apparaîtront à la lecture de la description détaillée d'un mode de réalisation donné à titre d'exemple, description illustrée par le dessin joint dans lequel :

La figure 1 représente schématiquement un amplificateur selon l'invention ;
La figure 2 représente des courbes caractéristiques représentatives du fonctionnement de plusieurs canons à électrons de l'amplificateur de la figure 1.

Par souci de clarté, les mêmes éléments porteront les mêmes repères dans les différentes figures.

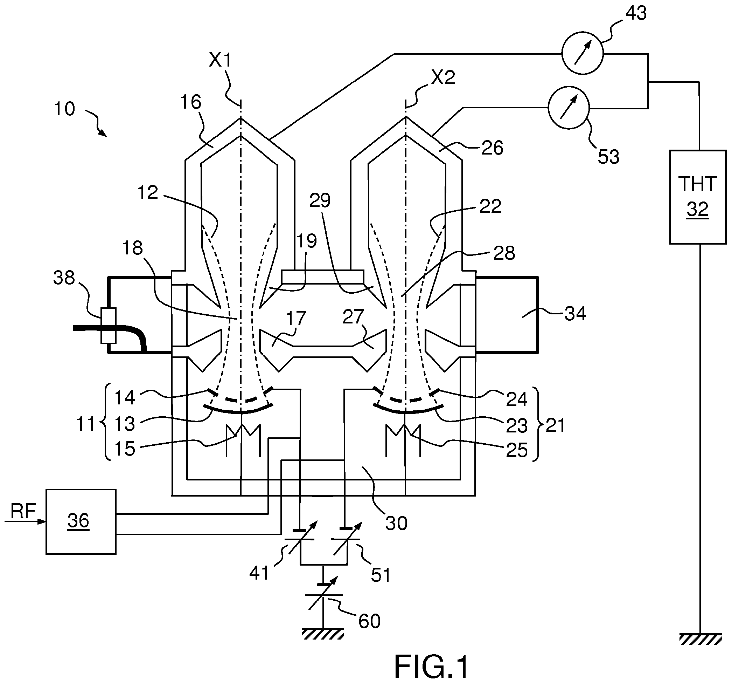

La figure 1 représente un amplificateur 10 destiné à amplifier un signal radiofréquence au moyen d'un tube à vide. On rappelle sommairement qu'un tube à vide utilise le principe de l'interaction entre un faisceau d'électrons et une onde électromagnétique, pour transmettre à l'onde une partie de l'énergie contenue dans le faisceau d'électrons, de manière à obtenir en sortie du tube une onde d'énergie plus grande que celle de l'onde injectée à l'entrée du tube. La fréquence du signal radiofréquence est par exemple dans la bande UHF. D'autres bandes de fréquence peuvent bien entendu être mise en œuvre dans le cadre de l'invention.

L'amplificateur 10 comprend, à titre d'exemple, deux canons à électrons 11 et 21 émettant chacun un faisceau, respectivement 12 et 22 dans une enceinte 30 à vide. Le nombre de canons a été choisi pour ne pas surcharger la figure. Il est bien entendu possible de mettre en œuvre l'invention pour un plus grand nombre de canons. La demanderesse a par exemple réalisé en interne des essais concluants pour un amplificateur possédant dix canons à électrons. Le canon 11 est construit autour d'un axe X1 le long duquel le faisceau d'électron 12 se propage. Le canon 11 est disposé à une première extrémité de l'axe X1. Le canon 11 comprend une cathode 13 qui émet les électrons et une grille 14 qui contrôle le flux d'électrons en fonction d'une tension qui lui est appliquée. Une électrode de chauffage 15 permet de chauffer la cathode 13. Le faisceau d'électrons 12 s'étend jusqu'à un collecteur 16 disposé à une deuxième extrémité de l'axe X1.

L'amplificateur 10 comprend une alimentation THT 32 permettant d'appliquer une différence de tension de plusieurs dizaines de kilovolts entre la cathode 13 et le collecteur 16. Dans la pratique, le collecteur 16 peut comporter plusieurs étages (non représentés) porté chacun à une tension différente.

Le long de l'axe X1, l'amplificateur 10 comprend une anode 17 ayant la forme d'un bec qui débouche dans un espace d'interaction 18 d'une cavité résonnante 34 de sortie. L'espace d'interaction 18 est délimité par un second bec d'interaction 19 qui fait face au bec 18 et appartenant au collecteur 16.

Le canon à électrons 21 est construit autour de l'axe X2 et comprend comme pour le canon 11, une électrode de chauffage 25, une cathode 23 et une grille 24. L'amplificateur 10 comprend également une anode 27 traversée par le faisceau 22 et un collecteur 26 destiné à recevoir le faisceau 22 émis par le canon 21. Le collecteur 26 et le canon 22 s'étendent tous deux le long d'un axe X2. Les deux axes X1 et X2 sont par exemple parallèles. D'autres configurations ou les axes X1 et X2 ne sont pas parallèles sont également possibles dans le cadre de l'invention.

Afin de standardiser la fabrication de l'amplificateur 10, les deux canons 11 et 21, les deux anodes 17 et 27 et les deux collecteurs 16 et 26 sont avantageusement identiques.

La cavité résonnante 34 de sortie est commune aux deux faisceaux d'électrons 12 et 22.

L'amplificateur 10 comprend un répartiteur 36 permettant de répartir le signal radiofréquence RF à amplifier entre les deux grilles 14 et 24 de façon équilibrée.

En fonctionnement, le faisceau d'électrons 12 est modulé en densité par la grille 14 et les électrons sont émis sous forme de paquets. La durée entre deux paquets est égale à la période du signal RF. Le faisceau 12 est sensiblement cylindrique autour de l'axe X1 entre l'anode 17 et le collecteur 16. Cette forme cylindrique est obtenue grâce d'une part à la forme de la cathode 13, de l'anode 17 et de la grille 14 et d'autre part grâce à un champ magnétique axial qui maintient les électrons près de l'axe X1. Les paquets d'électrons provenant de la grille 14 sont accélérés avant d'entrer dans l'espace d'interaction 18. Le champ électrique présent dans l'espace d'interaction 18 tend à freiner les paquets d'électrons. L'énergie cinétique perdue par les électrons est convertie en énergie électromagnétique dans la cavité 34. Le faisceau d'électrons 22 se développe de la même façon que le faisceau 12. Le faisceau 22 convertie également une partie de son énergie cinétique en énergie électromagnétique dans la cavité 34. L'énergie électromagnétique issue des deux faisceaux 12 et 22 est dirigée vers la sortie de l'amplificateur 10 par exemple par un coaxial au travers d'un isolant 38 réalisé dans la paroi de la cavité 34.

L'amplificateur 10 comprend en outre, associée à chaque canon 11 et 21, une alimentation en tension continue, respectivement 41 et 51, chacune des alimentations étant raccordée à la grille 14 ou 24 du canon correspondant 11 ou 21 de façon à polariser la grille. La tension des alimentations 41 et 51 est réglable de façon à équilibrer la densité des différents faisceaux 12 et 22.

Il est possible de compléter l'amplificateur 10 en y ajoutant une autre alimentation 60 en tension continue commune aux différents canons 11 et 21. La tension de chacune des alimentations 41 et 51 s'ajoute à celle de l'alimentation 60. L'alimentation 41 est raccordée en série entre la grille 14 et l'alimentation 60. De même, l'alimentation 51 est raccordée en série entre la grille 24 et l'alimentation 60. La présence de l'alimentation 60 permet de faciliter le réglage de la tension de blocage des différents faisceaux.

Il est possible de régler la tension de différentes alimentations 41, 51 et 60 en analysant le signal de sortie de l'amplificateur. Une autre façon plus simple consiste à mesurer les courants circulant dans chacun des collecteurs 16 et 26. A cet effet, les collecteurs 16 et 26 sont réalisés de façon séparée et peuvent être isolés électriquement l'un de l'autre de façon à mesurer séparément le courant généré par chacun des faisceau 12 et 22 dans chacun des collecteurs 16 et 26. Deux conducteurs électriques distincts relient les collecteurs 16 et 26 chacun à l'alimentation THT 32 et l'amplificateur comprend des capteurs de courant 43 et 53 permettant de mesurer séparément le courant circulant dans chacun des conducteurs. Autrement dit, le capteur 43 permet de mesurer le courant circulant dans le collecteur 16 et le capteur 53 permet de mesurer le courant circulant dans le collecteur 26. Tout type de capteur peut être utilisé pour mesurer ces courants, comme par exemple des capteurs à effet Hall mesurant le champ magnétique généré par le courant circulant dans le conducteur reliant le collecteur considéré à l'alimentation THT 32.

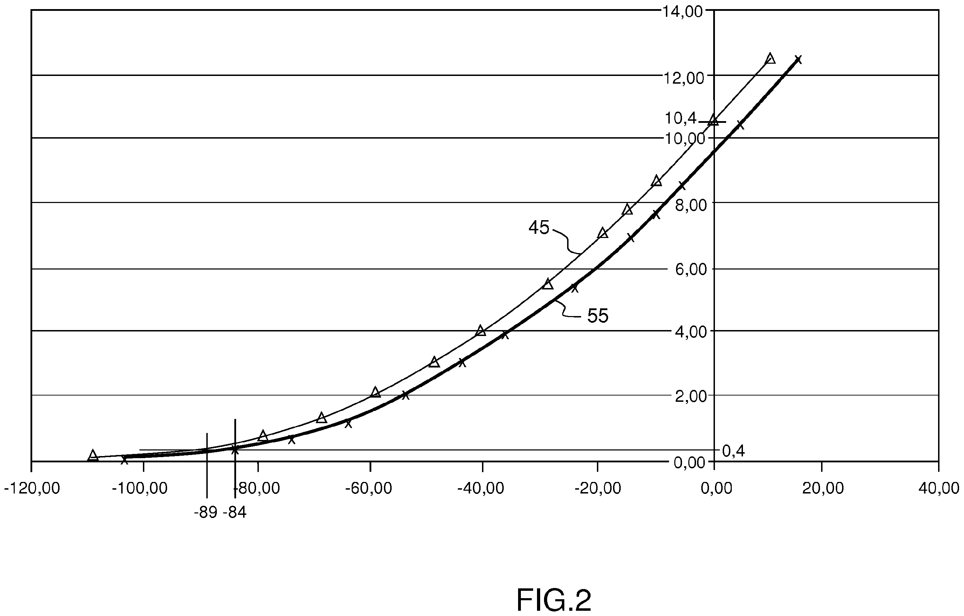

La figure 2 représente deux exemples de courbes caractéristiques 45 et 55 associée chacune à un des canons, respectivement 11 et 21. Plus précisément, les courbes 45 et 55 représentent l'évolution du courant circulant dans le collecteur en fonction de la tension appliquée à la grille considérée 14 ou 24. Pour chacune des courbes 45 et 55, le courant évolue de façon croissante en fonction de la tension appliquée à la grille. Pour une tension de grille d'environ -110V, le courant est nul et pour une tension de 0V le courant est d'environ 10A. Les deux courbes 45 et 55 sont décalées horizontalement. Ce décalage est principalement du aux dispersions géométriques des deux canons à électrons 11 et 21. Dans la pratique, toutes les autres pièces mécaniques intervenant dans l'établissement des deux faisceaux 12 et 22 peuvent générer des variations de courant dans les collecteurs 16 et 26.

Les deux courbes caractéristiques 45 et 55 sont établies pour l'application de signaux RF sur les grilles 14 et 24. La valeur des courants reste la même en cas d'application d'une tension continue à la grille considérée. La tension continue peut venir en complément de la tension alternative RF. En faisant varier les valeurs de tension des deux alimentations 41 et 51, il est donc possible d'équilibrer les deux canons à électrons 11 et 21 de façon à ce que pour une même puissance RF en entrée, les courants des deux faisceaux 12 et 22 soient égaux.

De façon simple, on règle en l'absence de signal RF chacune des deux tensions des alimentations 41 et 51 pour obtenir une même valeur de courant mesurée par les deux capteurs 43 et 53. La dérivée des courbes 45 et 55 est croissante. Autrement dit, la pente des courbes 45 et 55 augmente avec la tension de grille. Le choix de l'intensité du courant à atteindre dans les collecteurs 16 et 26 doit être suffisamment élevé pour obtenir un rapport entre variation de tension et variation de courant suffisant pour permettre un réglage fin de la tension. Par ailleurs, lors de l'application d'une tension continue sur chacune des grilles 14 et 24, la quasi totalité de l'énergie contenue dans les faisceaux d'électrons 12 et 22 est évacuée dans les collecteurs 16 et 26 quasiment sans transfert d'énergie cinétique vers la cavité 34. En conséquence, pour limiter l'échauffement des collecteurs 16 et 26, il est nécessaire de limiter l'intensité du courant dans chacun des collecteurs. En pratique un courant continu de l'ordre de 4% du courant maximum permet un réglage sans échauffement excessif du collecteur. Dans l'exemple représenté sur la figure 2, en suivant la courbe 45, une tension de 0V appliquée sur la grille 14 génère un courant de 10,5A dans le collecteur 16 et une tension de -89V génère un courant de 0,4A. Tout d'abord on règle la tension de l'alimentation 41 à -89V pour obtenir un courant d'une valeur cible de 0,4A. Alternativement, comme la valeur cible du courant est une valeur arbitraire, l'alimentation 41 peut être à tension fixe.

On cherche ensuite à déterminer la tension à appliquer à la grille 24 pour obtenir le même courant de 0,4A circulant dans le collecteur 26. Il est possible de fixer le potentiel de la grille également à -89V. A cette valeur de tension on mesure un courant dans le collecteur 26 inférieur à 0,4A. Comme on sait que la courbe 55 est croissante, on remonte la tension de l'alimentation 51 appliquée à la grille 24 jusqu'à atteindre la valeur de 0,4A dans le collecteur 26. Dans l'exemple représenté, le courant de 0,4A dans le collecteur 26 est atteint pour une tension continue de -84V pour l'alimentation 51.

Ce procédé peut être amélioré afin d'augmenter la précision de réglage des tensions des alimentations 41 et 51. Afin de limiter l'échauffement dans les collecteurs 16 et 26, il est possible d'appliquer une tension à une des grilles 14 et 24 que durant une fraction d'une période. L'inertie thermique des collecteurs 16 et 26 permet alors de lisser l'échauffement sur la période. La fraction de la période est définie de façon à permettre une mesure correcte du courant dans le collecteur. Par exemple, en utilisant un capteur à effet hall comme capteur de courant, une fraction de période de l'ordre de 1 à 2ms permet de stabiliser la mesure dans le capteur considéré. Hors de la fraction pendant laquelle la tension est appliquée à la grille, et pendant le reste de la période, la tension appliquée à la grille peut être plus négative afin de ne générer aucun courant dans le collecteur considéré. Il est possible de répéter l'application de la tension par exemple à une fréquence de 1 à 10Hz afin d'affiner la mesure de courant dans le collecteur, par exemple en calculant une moyenne entre les différentes mesures réalisées.

Après avoir réglé la tension des deux alimentations 41 et 51, on s'intéresse à l'alimentation 60 commune aux deux canons 11 et 21. La tension de l'alimentation 60 s'ajoute aux deux tensions précédemment réglées. Le réglage de l'alimentation 60 est réalisé de façon à annuler le courant dans les collecteurs. Cette tension, cumulée avec la tension de chacune des alimentations 41 et 51 est appelée tension de blocage. Autrement dit, pour le canon 11, la tension de blocage est la somme des tensions des alimentations 41 et 60. Pour le canon 21, la tension de blocage est la somme des tensions des alimentations 51 et 60. Dans l'exemple représenté, la tension de l'alimentation 60 est de -25V. La grille 14 est polarisée à sa tension de blocage $Vp_{14}$ qui est de :

$$Vp_{14} = (-89V) + (-25V) = -114V$$

De même, la grille 24 est polarisée à sa tension de blocage $Vp_{24}$ qui est de :

$$Vp_{24} = (-84V) + (-25V) = -109V.$$

Alternativement, il est possible de se passer de l'alimentation 60. On décale alors de la même valeur la tension de chacune des alimentations 41 et 51 pour arriver à la tension de polarisation souhaitée.

Après polarisation des différentes grilles, il est possible d'appliquer à chacune des grilles la tension $V_{RF}.\cos\omega t$ du signal RF en complément de sa tension de polarisation. Lors de l'utilisation de l'amplificateur 10, la tension $Vg_{24}$ appliquée à la grille 14 est :

$$Vg_{14}= Vp_{14} + V_{RF}.\cos\omega t$$

$$Vg_{24} = Vp_{24} + V_{RF}.\cos\omega t$$

La tension $V_{RF}$ est l'amplitude du signal RF. Si on ne souhaite pas dépasser un courant collecteur de 10,5A, l'amplitude maximum du signal RF est de 109V afin d'obtenir une tension maximum de 0V pour la grille 14 et une tension maximum de +5V pour la grille 24. Pour une même amplitude du signal RF, par exemple de 109 V, un même courant crête, soit 10.4 A, est délivré par chacun des canons 11 et 21.

**Revendications**

1. Amplificateur comprenant un tube à sortie inductive multifaisceau comprenant une cavité de sortie (34) et plusieurs canons à électrons (11, 21) destinés chacun à émettre un faisceau d'électrons (12, 22) traversant la cavité de sortie (34), chaque canon à électrons (11, 21) comprenant une cathode (13, 23) destinée à émettre le faisceau d'électrons (12, 22) et une grille (14, 24) permettant de moduler la densité du faisceau d'électrons (12, 22), l'amplificateur (10) comprenant en outre, associée à chaque canon (11, 21), une alimentation en tension continue (41, 51), chacune des alimentations (41, 51) étant raccordée à la grille (14, 24) du canon à électrons (11, 21) correspondant de façon à polariser la grille (14, 24), la tension d'au moins une des alimentations (41, 51) étant réglable de façon à équilibrer la densité des différents faisceaux d'électrons (12, 22).

2. Amplificateur selon la revendication 1, dans lequel les alimentations (41, 51) associées à chaque canon à électrons (11, 21) sont appelées premières alimentations et comprenant en outre une seconde alimentation (60) en tension continue réglable en tension, les premières alimentations (41, 51) étant chacune raccordée en série entre la grille correspondante (14, 24) et la seconde alimentation (60), la tension de la seconde alimentation (60) étant réglable de façon à appliquer aux différentes grilles (14, 24) une tension de blocage.

3. Amplificateur selon l'une des revendications précédentes, comprenant en outre, associé à chacun des canons à électrons (11, 21), un collecteur (16, 26), chaque collecteur (16, 26) étant destiné à recevoir le faisceau d'électrons (12, 22) correspondant après son passage dans la cavité de sortie (34), un capteur de courant (43, 53) permettant de mesurer un courant circulant dans chacun des collecteurs (16, 26).

4. Procédé de réglage d'un amplificateur (10) selon l'une des revendications précédentes, consistant à mesurer un courant circulant dans chacun des collecteurs (16, 26) et à régler la tension de chacune des premières alimentations (41, 51) pour rendre égales les valeurs mesurées des courants.

5. Procédé selon la revendication 4, dans lequel une valeur cible de courant mesuré dans chacun des collecteurs (16, 26) est définie de façon à limiter l'échauffement de chacun des collecteurs (16, 26).

6. Procédé selon l'une des revendications 4 ou 5, dans lequel une tension est appliquée à une des grilles (14, 24), tension permettant d'atteindre une valeur cible de courant mesuré dans chacun des collecteurs (16, 26) durant une fraction d'une période de temps.

7. Procédé selon la revendication 6, dans lequel la période de temps est répétée et dans lequel on calcule une moyenne des mesures de courant réalisées durant chacune des fractions.

**Patentansprüche**

1. Verstärker, beinhaltend eine Röhre mit induktivem mehrstrahligem Ausgang, beinhaltend einen Ausgangshohlraum (34) und mehrere Elektronenkanonen (11, 21), welche jeweils dazu bestimmt sind, einen Elektronenstrahl (12, 22) auszusenden, welcher den Ausgangshohlraum (34) durchquert, wobei jede Elektronenkanone (11, 21) eine Kathode (13, 23) beinhaltet, welche dazu bestimmt ist, den Elektronenstrahl (12, 22) auszusenden und ein Gitter (14, 24), welches dazu dient, die Dichte des Elektronenstrahls (12, 22) zu modulieren, wobei der Verstärker (10) zudem, einer jeden Kanone (11, 21) zugeordnet, eine Gleichspannungsspeisung (41, 51) beinhaltet, wobei jede der Speisungen (41, 51) an das Gitter (14, 24) der entsprechenden Elektronenkanone (11, 21) in einer Weise angeschlossen ist, dass sie das Gitter (14, 24) polarisiert, wobei die Spannung mindestens einer der Speisungen (41, 51) in einer Weise regelbar ist, dass die Dichte der unterschiedlichen Elektronenstrahlen (12, 22) ausgeglichen wird.

2. Verstärker nach Anspruch 1, bei welchem die einer jeden Elektronenkanone (11, 21) zugeordneten Speisungen (41, 51) erste Speisungen genannt werden, und welcher zudem eine zweite spannungsregelbare Gleichspannungs-Speisung (60) beinhaltet, wobei die ersten Speisungen (41, 51) jeweils in Reihe zwischen dem entsprechenden Gitter (14, 24) und der zweiten Speisung (60) angeschlossen sind, wobei die Spannung der zweiten Speisung (60) in einer Weise regelbar ist, dass eine Sperrspannung an die unterschiedlichen Gitter (14, 24) angelegt wird.

3. Verstärker nach einem der vorhergehenden Ansprüche, welcher zudem, einer jeden der Elektronenkanonen (11, 21) zugeordnet, einen Sammler (16, 26) beinhaltet, wobei jeder Sammler (16, 26) dazu bestimmt ist, den entsprechenden Elektronenstrahl (12, 22) aufzunehmen, nachdem dieser den Ausgangshohlraum (34) passiert hat, wobei ein Stromsensor (43, 53) es ermöglicht, einen in jedem der Sammler (16, 26) zirkulierenden Strom zu messen.

4. Verfahren zum Einstellen eines Verstärkers (10) nach einem der vorhergehenden Ansprüche, darin bestehend, einen in jedem der Sammler (16, 26) zirkulierenden Strom zu messen und die Spannung einer jeden der ersten Speisungen (41, 51) zu regeln, um die gemessenen Werte der Ströme gleich zu machen.

5. Verfahren nach Anspruch 4, bei welchem ein Zielwert eines in jedem der Sammler (16, 26) gemessenen Stroms so definiert wird, dass die Erhitzung eines jeden der Sammlers (16, 26) begrenzt wird.

6. Verfahren nach einem der Ansprüche 4 oder 5, bei welchem eine Spannung an eines der Gitter (14, 24) angelegt wird, wobei die Spannung es ermöglicht, einen Zielwert eines in jedem der Sammler (16, 26) gemessenen Stroms im Zuge einer Fraktion eines Zeitraums zu erreichen.

7. Verfahren nach Anspruch 6, bei welchem der Zeitraum wiederholt wird und bei welchem man einen Mittelwert der im Zuge einer jeden der Fraktionen vorgenommenen Strommessungen berechnet.

## Claims

1. An amplifier comprising a multibeam inductive output tube comprising an output cavity (34) and a plurality of electron guns (11, 21) that are each intended to emit an electron beam (12, 22) through the output cavity (34), each electron gun (11, 21) comprising a cathode (13, 23) that is intended to emit the electron beam (12, 22) and a gate (14, 24) allowing the density of the electron beam (12, 22) to be modulated, the amplifier (10) furthermore comprising, associated with each gun (11, 21), a DC voltage supply (41, 51), each of the supplies (41, 51) being connected to the gate (14, 24) of the corresponding electron gun (11, 21) so as to bias the gate (14, 24), the voltage of at least one of the supplies (41, 51) being adjustable so as to balance the density of the various electron beams (12, 22).

2. The amplifier as claimed in claim 1, wherein the supplies (41, 51) associated with each electron gun (11, 21) are called first supplies and furthermore comprising a second DC voltage supply (60) the voltage of which is adjustable, the first supplies (41, 51) each being connected in series between the corresponding gate (14, 24) and the second supply (60), the voltage of the second supply (60) being adjustable so as to apply, to the various gates (14, 24), a blocking voltage.

3. The amplifier as claimed in one of the preceding claims, furthermore comprising, associated with each of the electron guns (11, 21), a collector (16, 26), each collector (16, 26) being intended to receive the corresponding electron beam (12, 22) after it has passed through the output cavity (34), a current sensor (43, 53) allowing a current flowing through each of the collectors (16, 26) to be measured.

4. A method for adjusting an amplifier (10) as claimed in one of the preceding claims, consisting in measuring a current flowing through each of the collectors (16, 26) and in adjusting the voltage of each of the first supplies (41, 51) in order to equalize the measured values of the currents.

5. The method as claimed in claim 4, wherein a target value is defined for the current measured in each of the collectors (16, 26) so as to limit the heating of each of the collectors (16, 26).

6. The method as claimed in either of claims 4 and 5, wherein a voltage is applied to one of the gates (14, 24), this voltage allowing a target value to be achieved for the current measured in each of the collectors (16, 26) during a fraction of a time period.

7. The method as claimed in claim 6, wherein the time period is repeated and wherein an average of the current measurements taken during each of the fractions is calculated.

FIG.1

FIG.2

EP 3 360 151 B1